# FASCICULE DE BREVET EUROPEEN

(11) **EP 2 821 998 B1**
(45) Date de publication et mention de la délivrance du brevet: **24.03.2021**
(21) Numéro de dépôt: 14175842.5
(22) Date de dépôt: 04.07.2014
(51) Int. Cl.: G11C 11/00, G11C 13/00, G11C 11/16, G11C 14/00

(54) **Dispositif à mémoire non volatile**
Nichtflüchtige Speichervorrichtung
Non-volatile memory device

(30) Priorité: 05.07.2013 FR 1356637
(43) Date de publication de la demande: 07.01.2015
(73) Titulaire: COMMISSARIAT À L'ÉNERGIE ATOMIQUE ET AUX ÉNERGIES ALTERNATIVES, 75015 Paris (FR); CENTRE NATIONAL DE LA RECHERCHE SCIENTIFIQUE, 75794 Paris Cedex 16 (FR)
(72) Inventeur: Di Pendina, Grégory, 38054 GRENOBLE (FR); Javerliac, Virgile, 38100 GRENOBLE (FR)
(74) Mandataire: Cabinet Beaumont

(56) Documents cités:
- FR-A1- 2 970 589
- US-A1- 2009 190 409
- US-A1- 2009 268 513
- US-A1- 2010 188 891
- US-A1- 2011 095 255
- US-A1- 2011 122 709
- US-B1- 8 331 128

## Description

### Domaine

La présente description concerne un dispositif mémoire comprenant des éléments de mémorisation de données non volatile, et un procédé pour mémoriser des données en programmant des éléments de mémorisation de données non volatile d'un dispositif mémoire.

### Arrière-plan

On a déjà proposé d'utiliser des éléments résistifs programmables dans des cellules mémoires pour assurer une mémorisation de données non volatile. De tels éléments résistifs sont programmables pour prendre l'un d'une pluralité d'états résistifs différents. L'état résistif programmé est maintenu même lorsqu'une tension d'alimentation de la cellule mémoire est déconnectée, et ainsi des données peuvent être mémorisées par de tels éléments de manière non volatile.

On a proposé divers types d'éléments résistifs, dont certains peuvent être programmés par la direction d'un courant qu'on y fait passer. Un exemple d'un tel élément résistif programmable par un courant est un élément STT (à couple de transfert de spin), qui est basé sur des jonctions tunnel magnétiques (MTJ).

De tels éléments non volatils sont en général associés à une durée de rétention de données minimum pendant laquelle les données mémorisées par ces éléments peuvent être récupérées de façon fiable. Bien qu'il soit possible d'obtenir des éléments non volatils ayant des durées de rétention de données relativement longues, par exemple plusieurs années ou plus, plus la durée de rétention est longue, plus les opérations d'écriture des éléments tendent à être consommatrices d'énergie.

Il existe un besoin dans la technique pour un dispositif mémoire assurant un rendement énergétique amélioré pendant les opérations d'écriture.

La publication de la demande de brevet US 2009/0190409 concerne un circuit intégré comportant des cellules mémoires incluant au moins une cellule mémoire de surveillance et au moins une autre cellule mémoire, l'au moins une cellule mémoire de surveillance ayant une durée de rétention plus courte que l'au moins une autre cellule.

La publication de la demande de brevet US 2009/0268513 concerne une mémoire incluant un premier dispositif mémoire ayant une matrice de cellules à changement de phase.

Le document US 2011/0095255 décrit un dispositif mémoire comprenant un élément mémoire résistif.

### Résumé

Un objet de mode de réalisation de la présente description est de résoudre au moins partiellement un ou plusieurs problèmes de l'art antérieur.

Selon un aspect, on prévoit un dispositif mémoire comprenant : une première cellule mémoire comprenant un premier élément résistif de mémorisation de données non volatile programmable pour mémoriser un premier bit de données ; et une deuxième cellule mémoire comprenant un deuxième élément résistif de mémorisation de données non volatile programmable pour mémoriser un deuxième bit de données ; dans lequel une caractéristique physique du premier élément résistif est différente d'une caractéristique physique correspondante du deuxième élément résistif d'où il résulte que le premier élément résistif a une première durée de rétention de données, et le deuxième élément résistif a une deuxième durée de rétention de données différente de la première durée de rétention de données, le dispositif mémoire étant configuré pour recevoir un signal de commande indiquant une durée de rétention pour sélectionner l'un des premier et deuxième éléments résistifs pour mémoriser une valeur de donnée d'entrée, ladite durée de rétention étant associée à la valeur de donnée d'entrée; et caractérisé en ce que : chacune des première et deuxième cellules mémoires est couplée à un circuit de lecture-écriture permettant de lire et d'écrire des données dans les première et deuxième cellules mémoires, le circuit de lecture-écriture comprenant un comparateur ayant une entrée couplée à une première ligne de bit et une sortie couplée à une bascule de verrouillage, la bascule de verrouillage étant couplée à son tour à des éléments de pilotage, qui ont leur sorties couplées respectivement à la première ligne de bit et à une deuxième ligne de bit, la bascule de verrouillage recevant un signal de données représentant des données à mémoriser dans la première ou deuxième cellule mémoire, et fournissant des données lues d'une des première et deuxième cellules mémoires ; le circuit de lecture-écriture est agencé pour transférer des données entre les première et deuxième cellules mémoires ; et la première cellule mémoire est couplée au circuit de lecture-écriture par l'intermédiaire de la première et d'une deuxième ligne de bit, et la deuxième cellule mémoire est couplée au circuit de lecture-écriture soit par l'intermédiaire de la première et de la deuxième ligne de bit, soit par l'intermédiaire d'une troisième et d'une quatrième ligne de bit.

Selon un mode de réalisation, la deuxième durée de rétention de données est au moins 50 pourcent plus courte ou plus longue que la première durée de rétention de données.

Selon un mode de réalisation, la deuxième durée de rétention de données est au moins 10 fois plus courte ou plus longue que la première durée de rétention de données.

Selon un mode de réalisation, au moins une dimension du premier élément résistif, autre que son épaisseur, est différente d'une dimension correspondante du deuxième élément résistif.

Selon un mode de réalisation, chacun des premier et deuxième éléments résistifs est l'un des éléments suivants : un élément à couple de transfert de spin ayant une anisotropie dans le plan ; un élément à couple de transfert de spin ayant une anisotropie perpendiculaire au plan ; un élément à commutation assistée thermiquement ; un élément à oxydo-réduction (RedOx) ; un élément ferroélectrique ; et un élément à changement de phase.

Selon un mode de réalisation, chacun des premier et deuxième éléments résistifs est un élément à couple de transfert de spin ayant une anisotropie dans le plan ou une anisotropie perpendiculaire au plan et est constitué d'une pluralité de couches empilées, le volume d'au moins l'une des couches du premier élément étant différent de celui de la couche correspondante du deuxième élément.

Selon un aspect, on prévoit un procédé pour mémoriser une valeur de donnée d'entrée dans une mémoire non volatile d'un dispositif mémoire, le dispositif mémoire comprenant une première cellule mémoire comprenant un premier élément résistif de mémorisation de données non volatile programmable pour mémoriser un premier bit de données ; et une deuxième cellule mémoire comprenant un deuxième élément résistif de mémorisation de données non volatile programmable pour mémoriser un deuxième bit de données, dans lequel une caractéristique physique du premier élément résistif est différente d'une caractéristique physique correspondante du deuxième élément résistif d'où il résulte que le premier élément résistif a une première durée de rétention de données, et le deuxième élément résistif a une deuxième durée de rétention de données différente de la première durée de rétention de données, et caractérisé en ce que : chacune des première et deuxième cellules mémoires est couplée à un circuit de lecture-écriture permettant de lire et d'écrire des données dans les première et deuxième cellules mémoires, le circuit de lecture-écriture comprenant un comparateur ayant une entrée couplée à une première ligne de bit et une sortie couplée à une bascule de verrouillage, la bascule de verrouillage étant couplée à son tour à des éléments de pilotage, qui ont leur sorties couplées respectivement à la première ligne de bit et à une deuxième ligne de bit, la bascule de verrouillage recevant la valeur de donnée d'entrée et fournissant des données lues d'une des première et deuxième cellules mémoires ; le circuit de lecture-écriture est agencé pour transférer des données entre les première et deuxième cellules mémoires ; et la première cellule mémoire est couplée au circuit de lecture-écriture par l'intermédiaire de la première et d'une deuxième ligne de bit, et la deuxième cellule mémoire est couplée au circuit de lecture-écriture soit par l'intermédiaire de la première et de la deuxième ligne de bit, soit par l'intermédiaire d'une troisième et d'une quatrième ligne de bit, et en ce que le procédé comprend : sélectionner, sur la base d'une durée de rétention de données associée à la valeur de donnée d'entrée, l'un des premier et deuxième éléments résistifs ; et programmer l'élément résistif sélectionné pour mémoriser la valeur de donnée d'entrée.

### Brève description des dessins

Les caractéristiques et avantages susmentionnés, et d'autres, apparaîtront clairement à la lecture de la description détaillée suivante de modes de réalisation, donnée à titre illustratif et non limitatif, en référence aux dessins joints dans lesquels :
la figure 1A illustre schématiquement un dispositif mémoire selon un mode de réalisation de la présente description ;
la figure 1B est un chronogramme illustrant des données mémorisées par le dispositif de la figure 1 selon un exemple de réalisation ;
la figure 2 illustre schématiquement le dispositif de la figure 1A plus en détail selon un exemple de réalisation de la présente description ;
les figures 3A et 3B sont des chronogrammes représentant des signaux dans le circuit de la figure 2 pendant une phase de transfert de données selon un exemple de réalisation de la présente description ;
les figures 4A et 4B sont des chronogrammes représentant des signaux dans le circuit de la figure 2 pendant une phase d'écriture selon un exemple de réalisation de la présente description ;
la figure 5 illustre schématiquement plus en détail le dispositif de la figure 1A selon un autre exemple de réalisation de la présente description ;
La figure 6A est un chronogramme représentant des signaux dans le circuit de la figure 5 pendant une phase d'écriture selon un exemple de réalisation de la présente description ;
la figure 6B est un chronogramme représentant des signaux dans le circuit de la figure 5 pendant une phase de transfert de donnée selon un exemple de réalisation de la présente description ;
les figures 7A et 7B illustrent des éléments résistifs basés sur des jonctions tunnel magnétiques selon des exemples de réalisation de la présente description ;
La figure 8 illustre schématiquement plus en détail le dispositif de la figure 1A selon un autre exemple de réalisation de la présente description ;
les figures 9A et 9B sont des chronogrammes illustrant des étapes dans des procédés de transfert de données dans le dispositif de la figure 8 ; et
la figure 10 illustre schématiquement le dispositif de la figure 1A plus en détail selon encore un autre exemple de réalisation de la présente description.

### Description détaillée

Dans la description suivante, on décrit des modes de réalisation spécifiques dans lesquels les états résistifs d'éléments résistifs non volatils des cellules mémoires sont programmés par la direction d'un courant qu'on fait passer dans ceux-ci. Il sera cependant clair pour l'homme de l'art que les principes décrits ici pourraient également s'appliquer à d'autres types d'éléments non volatils, comme ceux qui sont programmés par la direction d'un champ magnétique ou par l'amplitude d'un courant qu'on y fait passer, et des éléments mémorisant des données sous d'autres formes qu'une résistance programmée.

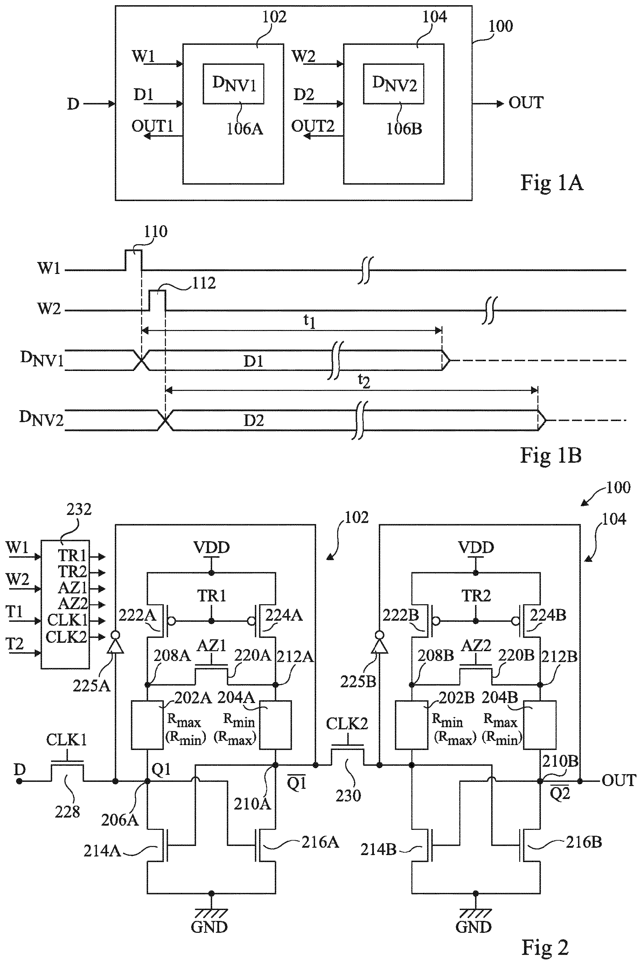

La figure 1A illustre schématiquement un dispositif mémoire 100 selon un exemple de réalisation.

Le dispositif 100 comprend des cellules mémoires 102 et 104. La cellule mémoire 102 comporte des entrées pour recevoir un signal de données D1 et un signal de phase d'écriture W1, et une sortie pour fournir une donnée de sortie OUT1. La cellule mémoire 104 comporte des entrées pour recevoir un signal de données D2 et un signal de phase d'écriture W2, et une sortie pour fournir une donnée de sortie OUT2.

Le dispositif 100 reçoit par exemple une donnée d'entrée D, et fournit une donnée de sortie OUT. Les valeurs des données d'entrée D1 et D2 appliquées aux cellules mémoires peuvent être égales à la donnée d'entrée D, ou l'une ou les deux valeurs de données D1, D2 peuvent être indépendantes de cette valeur de données.

La cellule mémoire 102 comprend au moins un élément de mémorisation de données non volatile 106A qui mémorise un bit de données D_{NV1} de façon non volatile. De façon similaire, la cellule mémoire 104 comprend au moins un élément de mémorisation de données non volatile 106B qui mémorise un bit de données D_{NV2} de façon non volatile. Comme cela apparaîtra clairement avec les modes de réalisation spécifiques décrits ci-après, les valeurs des bits de données D_{NV1} et D_{NV2} peuvent être complètement indépendantes entre elles.

Les éléments 106A, 106B sont d'un type quelconque d'élément de mémorisation non volatile. Par exemple, ils peuvent être d'un type d'élément à commutation de résistance dans lequel la résistance est programmable, par exemple par la direction d'un courant qu'on y fait passer. Dans certains modes de réalisation, les éléments résistifs 106A, 106B sont tous les deux du même type, mais dans d'autres modes de réalisation, il serait possible d'utiliser des types différents d'éléments non volatils pour mettre en oeuvre chacun d'eux.

Les éléments 106A, 106B sont par exemple basés sur des jonctions tunnel magnétiques (MTJ), comme des éléments à commutation magnétique induite par champ (FIMS), des éléments à commutation assistée thermiquement (TAS), des éléments STT (à transfert de couple de spin), ou ceux de MRAM à bascule. Des FIMS-MRAM (mémoires à accès aléatoire magnétiques) sont par exemple décrites plus en détail dans la publication intitulée "Magnetorésistive random access memory using magnetic tunnel junctions", S. Tehrani, Proceedings of IEEE, 91(5):3707-714, May 2003. Des TAS-MRAM sont par exemple décrites plus en détail dans la publication intitulée "Thermally Assisted MRAM", Prejbeanu et al.

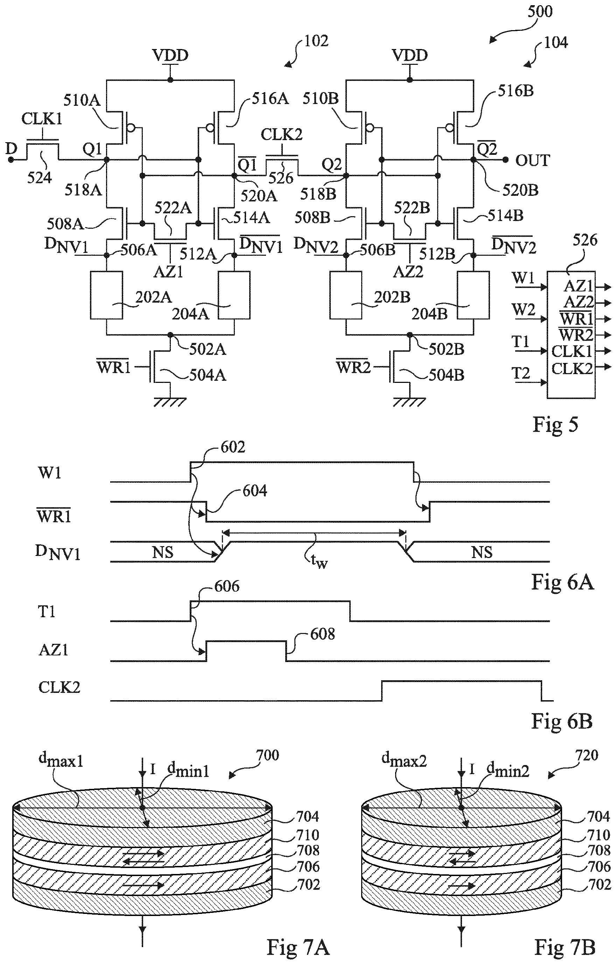

Dans un autre exemple décrit plus en détail ci-après en référence aux figures 7A et 7B, les éléments 106A, 106B sont des éléments à couple de transfert de spin ayant une anisotropie dans le plan ou perpendiculaire au plan, comme cela est décrit plus en détail dans la publication intitulée "Magnonic spin-transfer torque MRAM with low power, high speed, and error-free switching", N.Mojumder et al., IEDM Tech. Digest (2010), et dans la publication intitulée "Electric toggling of magnets", E. Tsymbal, Natural Materials Vol 11, January 2012.

En variante, les éléments 106A, 106B pourraient être d'autres types d'éléments de mémorisation non volatile, comme des dispositifs mémoire à commutation de résistance, comprenant ceux qui sont utilisés dans des cellules à métallisation programmable (PMC), comme des RAM résistives à oxyde (OxRRAM), des RAM à pontage conducteur (CBRAM), des FeRAM (RAM ferroélectriques) ou des RAM à changement de phase (PCRAM). Dans un autre exemple, les éléments 202, 204 pourraient être ceux utilisés dans des RAM RedOX (RAM à oxydo-réduction), qui par exemple sont décrites plus en détail dans la publication intitulée "Redox-Based Resistive Switching Memories - Nanoionic Mechanisms, Prospects and Challenges", Rainer Waser et al., Advanced Materials 2009, 21, pages 2632 to 2663.

Le signal de phase d'écriture W1 contrôle une phase d'écriture de la donnée D_{NV1} mémorisée par l'élément 106A, et le signal de phase d'écriture W2 contrôle une phase d'écriture de la donnée D_{NV2} mémorisée par l'élément 106B.

Chacune des cellules mémoires 102, 104 comprend par exemple un circuit mettant en oeuvre une bascule de verrouillage de données (non illustrée en figure 1A), et un signal d'horloge CLK1 peut en outre être fourni à la cellule mémoire 102 pour contrôler l'instant où le signal de données d'entrée D1 est verrouillé dans la cellule mémoire 102, et un signal d'horloge CLK2 peut en outre être fourni à la cellule mémoire 104 pour contrôler l'instant où la donnée d'entrée D2 est verrouillée dans la cellule mémoire 104.

Chacun des éléments 106A, 106B est associé à une durée de rétention, correspondant à la durée pendant laquelle les données D_{NV1}, D_{NV2} sont mémorisées de façon fiable par les éléments respectifs 106A, 106B. A la fin de la durée de rétention, il y a une probabilité significative qu'il ne soit plus possible de récupérer la valeur de donnée d'origine. Comme on va le décrire maintenant plus en détail en faisant référence à la figure 1B, les éléments résistifs 106A et 106B ont des différences physiques entre eux, ce qui signifie que la durée de rétention de l'élément 106A n'est pas la même que la durée de rétention de l'élément 106B.

La figure 1B est un chronogramme illustrant les signaux d'écriture W1 et W2, et les données D_{NV1} et D_{NV2} des cellules mémoires 102 et 104 respectivement selon un exemple de réalisation.

Comme cela est illustré, une impulsion haute 110 du signal d'écriture W1 correspond par exemple à une phase d'écriture de la cellule mémoire 102 pendant laquelle une valeur de données D1 est écrite dans l'élément 106A, de sorte que la valeur de DNV₁ devient D1 à la fin de l'impulsion haute 110. On supposera ensuite qu'il n'y a pas de nouvelle phase d'écriture, l'élément résistif 106A maintenant la valeur D1 jusqu'à la fin de sa durée de rétention t₁, qui est par exemple comprise entre plusieurs secondes et plusieurs années.

Une impulsion haute 112 du signal d'écriture W2 peu de temps après l'impulsion haute 110 correspond par exemple à une phase d'écriture de la cellule mémoire 104 pendant laquelle la valeur de données D2 est écrite dans l'élément 106B, de sorte que la valeur de D_{NV2} devient D2 à la fin de l' impulsion haute 110. On suppose ici encore qu'il n'y a pas de nouvelle phase d'écriture, et que l'élément résistif 106B maintient la valeur D2 jusqu'à la fin de sa durée de rétention t₂. Comme cela est illustré, la durée de rétention t₂ est plus longue que t₁, mais dans des variantes de réalisation, elle pourrait être plus courte. Par exemple, la durée t₂ est au moins 50 pourcent plus longue ou plus courte que t₁. Dans certains modes de réalisation, la durée t₂ est au moins 10 fois plus longue ou plus courte que t₁. Dans un exemple, t₁ est inférieure ou égale à 1 mois et t₂ est supérieure ou égale à 12 mois, ou vice-versa.

Dans certains modes de réalisation, un procédé de sélection de la durée de rétention de données de la valeur de donnée d'entrée à mémoriser de façon non volatile implique de programmer sélectivement les éléments 106A ou 106B avec la valeur de donnée d'entrée sur la base d'une durée de rétention souhaitée. Par exemple, un signal de commande est fourni au dispositif mémoire 100 indiquant la durée de rétention de données souhaitée pour un bit de données donné. Pour des valeurs de données qu'il est seulement nécessaire de mémoriser pendant de courtes périodes, l'élément ayant la période de rétention la plus faible peut être sélectionné, ce qui économise de l'énergie.

Le dispositif mémoire 100 de la figure 1 est par exemple d'un type quelconque de dispositif à mémoire non volatile comprenant une pluralité de cellules mémoires, et pourrait être mis en oeuvre sous forme d'un dispositif mémoire séquentiel, combinatoire, synchrone ou asynchrone. Par exemple, le dispositif 100 couplé correspond à un unique réseau mémoire comprenant les cellules mémoires 102 et 104 en tant que deux de ses cellules adressables. En variante, une ou plusieurs des cellules adressables d'un dispositif mémoire pourraient constituer le dispositif mémoire 100.

La figure 2 illustre schématiquement plus en détail le dispositif mémoire 100 de la figure 1A selon un exemple de réalisation, dans le cas où le dispositif 100 est un dispositif synchrone. En particulier, dans l'exemple de la figure 2, les cellules mémoires 102, 104 sont couplées entre elles pour former une bascule.

Chacune des cellules mémoires 102, 104 comprend deux éléments résistifs, référencés 202A et 204A dans la cellule mémoire 102, et 202B et 204B dans la cellule mémoire 104, formant les éléments de mémorisation de données non volatile. Un bit de données est par exemple mémorisé dans chaque cellule mémoire d'une manière non volatile en plaçant l'un des éléments à une résistance relativement élevée Rₘₐₓ, et l'autre à une résistance relativement faible Rₘᵢₙ. En figure 2, les éléments 202A et 204B sont représentés programmés pour avoir une résistance Rₘₐₓ et les éléments 204A et 202B une résistance Rₘᵢₙ, et comme cela est représenté par les références Rₘᵢₙ et Rₘₐₓ entre parenthèses, la programmation opposée des valeurs de résistances serait possible.

Chacun des éléments résistifs 202A, 204A, 202B, 204B a par exemple seulement deux états résistifs correspondant aux résistances haute et basse Rₘₐₓ et Rₘᵢₙ, mais les valeurs exactes de Rₘᵢₙ et Rₘₐₓ peuvent varier en fonction de conditions comme le procédé de fabrication, les matériaux, les variations de température, etc.

Le bit de donnée non volatile représenté par les éléments résistifs 202A, 204A, ou par les éléments résistifs 202B, 204B, dépend duquel des éléments résistifs a la résistance Rₘₐₓ ou Rₘᵢₙ, en d'autres termes des résistances relatives. Les éléments résistifs sont par exemple sélectionnés de telle sorte que Rₘₐₓ soit toujours notablement supérieure à Rₘᵢₙ, par exemple supérieure d'au moins 20 pourcent. En général, le rapport entre la résistance Rₘₐₓ et la résistance Rₘᵢₙ est par exemple compris entre 1,2 et 10000. Rₘᵢₙ est par exemple égale à environ 2 kilo-ohms ou moins, et Rₘₐₓ est par exemple égale à environ 6 kilo-ohms ou plus, bien que de nombreuses autres valeurs soient possibles.

Il sera clair pour l'homme de l'art que dans certains modes de réalisation, plutôt que les éléments résistifs 202A, 204A de la cellule mémoire 102 soient tous les deux programmables, un seul pourrait être programmable. De façon similaire, plutôt que les éléments résistifs 202B, 204B de la cellule mémoire 104 soit tous les deux programmables, un seul pourrait être programmable. Dans de tels cas, l'autre élément résistif de chaque cellule mémoire a par exemple une résistance fixe à un niveau intermédiaire environ à mi-chemin entre Rₘᵢₙ et Rₘₐₓ, par exemple égal, avec une tolérance de 10 pourcent, à (Rₘᵢₙ+(Rₘₐₓ-Rₘᵢₙ)/2). Par exemple, l'un des éléments résistifs 202A, 204A et/ou 202B, 204B pourrait correspondre à une résistance de valeur fixe. En variante, l'un des éléments résistifs 202A, 204A et/ou 202B, 204B pourrait être constitué de deux éléments résistifs programmables couplés en parallèle et dans des orientations opposées, de telle sorte que quelque soit le sens dans lequel chaque élément est programmé, la valeur de résistance reste relativement constante au niveau intermédiaire.

En faisant référence maintenant à la cellule mémoire 102, l'élément résistif 202A est couplé entre un noeud de mémorisation 206A et un noeud intermédiaire 208A. L'élément résistif 204A est couplé entre un noeud de mémorisation 210A et un noeud intermédiaire 212A. Les noeuds de mémorisation 206A et 210A mémorisent des tensions Q1 et Q̅1̅ respectivement. Deux inverseurs sont couplés de façon croisée entre les noeuds de mémorisation 206A et 210A pour former une bascule de données. Chaque inverseur est constitué d'un seul transistor 214A, 216A respectivement. Le transistor 214A est par exemple un transistor MOS à canal N (NMOS) couplé par ses noeuds de courant principaux entre le noeud 206A et la masse. Le transistor 216A est par exemple un transistor NMOS couplé par ses noeuds de courant principaux entre le noeud de mémorisation 210A et la masse. Un noeud de commande du transistor 214A est couplé au noeud de mémorisation 210A, et un noeud de commande du transistor 216A est couplé au noeud de mémorisation 206A. Les noeuds intermédiaires 208A et 212A sont couplés entre eux par l'intermédiaire des noeuds de courant principaux d'un transistor NMOS 220A. Le transistor 220A reçoit sur son noeud de commande un signal AZ1 décrit plus en détail ci-après.

Le noeud 208A est en outre couplé à une tension d'alimentation V_{DD} par l'intermédiaire des noeuds de courant principaux d'un transistor MOS à canal P (PMOS) 222A. De façon similaire, le noeud 212A est couplé à la tension d'alimentation V_{DD} par l'intermédiaire des noeuds de courant principaux d'un transistor PMOS 224A. Les noeuds de commande des transistors PMOS 222A et 224A sont couplés ensemble à un signal de transfert TR1 décrit plus en détail ci-après.

La cellule mémoire 102 comprend par exemple en outre un inverseur 225A couplé entre le noeud de mémorisation 206A et le noeud de mémorisation 210A, bien que dans certains modes de réalisation, cet inverseur puisse être omis.

La cellule mémoire 104 est par exemple sensiblement identique à la cellule mémoire 102, et les composants ont été référencés avec de mêmes références numériques, excepté que le "A" de chaque référence a été remplacé par un "B". Comme avec la cellule mémoire 102, dans certains modes de réalisation, l'inverseur 225B pourrait être omis. Les tensions sur les noeuds de mémorisation 206B, 210B sont référencées Q2 et Q̅2̅ respectivement. Le transistor 220B est contrôlé par un signal AZ2 et les transistors 222B et 224B sont contrôlés par un signal TR2.

Le noeud de mémorisation 206A reçoit un signal de données d'entrée D par l'intermédiaire d'un transistor NMOS 228. Le noeud de mémorisation 210A de la cellule mémoire 102 est par exemple couplé au noeud de mémorisation 206B de la cellule mémoire 104 par l'intermédiaire d'un transistor NMOS 230. Le transistor 228 est par exemple contrôlé par le signal d'horloge CLK1, et les transistors 230 et 226B sont par exemple contrôlés par le signal d'horloge CLK2.

La figure 2 illustre aussi un bloc de commande 232, fournissant les signaux de commande TR1, TR2, AZ1, AZ2, CLK1 et CLK2 aux transistors correspondants des cellules mémoires 102, 104. Comme cela est illustré, ces signaux de commande sont par exemple générés sur la base des signaux d'écriture W1, W2 et des signaux de phase de transfert T1 et T2.

Dans la cellule mémoire 102, chaque inverseur de la bascule de données est mis en oeuvre par un unique transistor 214A, 216A, et l'état haut de Q1 ou Q̅1̅ est maintenu par le courant de fuite passant dans les transistors PMOS 222A ou 224A. Les tensions de seuil des transistors PMOS 222A et 224A sont choisies pour être inférieures à celles des transistors NMOS 214A et 216A respectivement, de sorte que lorsqu'ils sont dans l'état non-conducteur, le courant de fuite dans les transistors 222A ou 224A est supérieur à celui dans les transistors 214A ou 216A respectivement, maintenant ainsi le noeud correspondant 206A ou 210A à une tension suffisamment haute pour être vue comme un état logique haut. En d'autres termes, le courant de fuite I_{offP} passant dans le transistor PMOS 222A, 224A lorsqu'une tension haute est appliquée aux noeuds de grille correspondants est supérieur au courant de fuite I_{offN} passant dans le transistor NMOS correspondant 214A, 216A lorsqu'une tension basse est appliquée à son noeud de grille. Les tensions de seuil particulières vont dépendre de la technologie utilisée. A titre d'exemple, les tensions de seuil des transistors PMOS 222A, 224A sont choisies pour être dans une plage de 0,3 à 0,5 V, alors que les tensions de seuil des transistors NMOS 214A, 216A sont choisies de façon à être dans la plage de 0,4 à 0,6 V. Dans tous les cas, le rapport I_{offp}/I_{offn} est sélectionné par exemple de façon à être supérieur à 25, et de préférence supérieur à 100. La description susmentionnée s'applique mutatis mutandis à la cellule mémoire 104.

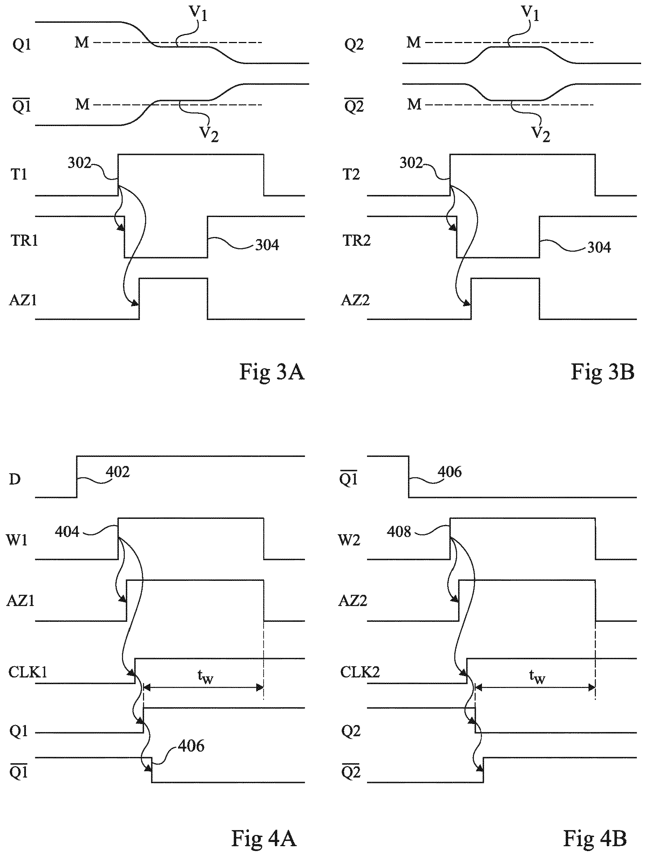

Le fonctionnement du circuit de la figure 2 va maintenant être décrit plus en détail en faisant référence aux figures 3A et 3B, et 4A et 4B.

D'abord, on notera que chacune des cellules mémoires 102, 104 peut mémoriser, de façon volatile, un bit de données qui est indépendant des états résistifs programmés des éléments 202A et 204A ou des éléments 202B et 204B. En effet, la bascule formée par les transistors 214A/214B et 216A/216B va maintenir tout état mémorisé.

Les figures 3A et 3B sont des chronogrammes représentant des signaux dans la cellule mémoire de la figure 2 pendant une phase de transfert des cellules mémoires 102 et 104 respectivement.

La figure 3A illustre les signaux de données Q1 et Q̅1̅ présents sur les noeuds de mémorisation 206A et 210A, le signal de phase de transfert T1, le signal de transfert TR1, et le signal AZ1 pendant une phase de transfert de la cellule mémoire 102. La phase de transfert correspond à une opération destinée à transférer la donnée représentée par les états résistifs programmés des éléments résistifs 202A et 204A vers les noeuds de mémorisation 206A, 210A. Ainsi, la donnée est transformée d'une représentation par les états résistifs programmés en une représentation par des niveaux de tension sur les noeuds de mémorisation 206A et 210A. La phase de transfert implique l'établissement des niveaux des tensions Q1 et Q̅1̅ en fonction des états résistifs programmés.

Dans l'exemple de la figure 3A, on a supposé que l'élément résistif 202A a été programmé pour avoir une résistance haute Rₘₐₓ, et l'élément résistif 204A une résistance basse Rₘᵢₙ. Bien que cela ne soit pas représenté dans les figures 3A et 3B, pendant la phase de transfert, les signaux d'horloge CLK1 et CLK2 par exemple restent bas. On a aussi supposé que Q1 et Q̅1̅ sont initialement respectivement à un état haut et un état bas. Le terme "état haut" est utilisé ici pour désigner un niveau de tension à proximité ou égal au niveau de la tension d'alimentation V_{DD}, tandis que le terme "état bas" est utilisé ici pour désigner un niveau de tension proche ou égal à la tension de masse. Le signal de transfert TR1 est par exemple initialement haut, de sorte que les transistors 222A et 224A sont non conducteurs. Le signal AZ1 est par exemple initialement bas, de sorte que le transistor 220A est non conducteur.

Le signal de phase de transfert T1, qui est par exemple initialement bas, est activé comme cela est représenté par un front montant 302, déclenchant peu après un front descendant du signal de transfert TR1, et un front montant du signal AZ1, par exemple peu après le front descendant du signal de transfert TR1. Ainsi, les transistors 220A, 222A et 224A sont tous activés, induisant un courant dans les branches de gauche et de droite de la cellule mémoire 102. Toutefois, en raison de la différence entre les résistances des éléments résistifs 202A et 204A, le courant dans la branche de gauche est inférieur au courant dans la branche de droite. Ainsi, ces courants par exemple provoquent une chute de la tension sur le noeud de mémorisation 206A pour descendre et s'établir à un niveau V₁ en dessous d'un niveau de métastabilité M, et une montée de la tension sur le noeud de mémorisation 210A à un niveau V₂ supérieur au niveau de métastabilité M. Le niveau de métastabilité M est un niveau de tension théorique environ à mi-chemin entre les états de tension haut et bas, représentant le niveau à partir duquel il y a une probabilité égale que Q1 bascule vers l'état haut ou l'état bas. Le fait d'activer le signal AZ1 pour rendre le transistor 220A passant a pour effet d'accélérer la descente du niveau de tension Q1, et la montée du niveau de tension Q̅1̅ .

Le signal AZ1 est ensuite amené à l'état bas, et le signal de transfert TR1 est amené de nouveau à l'état haut sur un front montant 304, de sorte que les niveaux de Q1 et Q̅1̅ vont vers leur état stable le plus proche, qui dans l'exemple de la figure 3A correspond à l'état Q1 bas et Q̅1̅ haut. Toutefois, il sera clair pour l'homme de l'art que les niveaux V₁ et V₂, et l'état stable final, vont dépendre de facteurs tels que les résistances à l'état conducteur des transistors 214A, 216A, 222A et 224A. Finalement, le signal de phase de transfert T1 passe à l'état bas pour achever la phase de transfert.

La figure 3B illustre les signaux de données Q2 et Q̅2̅ présents sur les noeuds de mémorisation 206B et 210B, le signal de phase de transfert T2, le signal de transfert TR2, et le signal AZ2 pendant une phase de transfert de la cellule mémoire 104. Dans l'exemple de la figure 3B, on a supposé que l'élément résistif 202B a été programmé pour avoir une résistance élevée Rₘₐₓ, et l'élément résistif 204B une résistance basse Rₘᵢₙ, et que les tensions Q2 et Q̅2̅ sont initialement à un état bas et à un état haut, respectivement. Le signal de phase de transfert T2, le signal de transfert TR2 et le signal AZ2 ont les mêmes formes que les signaux correspondants en figure 3A, et ne vont pas être décrits de nouveau. La différence par rapport à la figure 3A est que, lorsque le signal TR2 est amené à l'état bas et le signal AZ2 est amené à l'état haut, la tension Q2 monte vers le niveau V₁, et la tension Q̅2̅ descend vers le niveau V₂. Après cela, les niveaux de Q2 et Q̅2̅ vont vers leurs états stables le plus proche, qui dans l'exemple de la figure 3B correspond à l'état Q2 bas, Q̅2̅ haut. Ici encore, il sera clair pour l'homme de l'art que les niveaux V₁ et V₂, et l'état stable final, vont dépendre de facteurs tels que les résistances à l'état conducteur des transistors 214B, 216B, 222B et 224B.

La figure 4A est un chronogramme illustrant des exemples des signaux D, W1, AZ1, CLK1, Q1 et Q̅1̅ dans la cellule mémoire 102 pendant une phase d'écriture des états résistifs des éléments résistifs 202A et 204A. Bien que cela ne soit pas représenté en figure 4A, pendant la phase d'écriture, le signal de transfert TR1 par exemple reste haut de sorte que les transistors 222A et 224A sont non conducteurs.

La phase d'écriture implique le passage d'un courant dans chacun des éléments résistifs 202A, 204A par l'intermédiaire du transistor 220A, soit dans la direction allant du noeud de mémorisation 206A vers le noeud de mémorisation 210A, soit dans la direction opposée. Chacun des éléments résistifs 202 et 204 est orienté de telle sorte que, pour une direction donnée du courant, ils vont être programmés de façon à avoir des résistances opposées. En particulier, chaque élément résistif 202A, 204A peut être orienté selon l'une de deux façons entre le noeud de mémorisation correspondant 206A, 210A et le noeud intermédiaire 208A, 212A correspondant. Dans le cas d'un élément STT, l'orientation est déterminée par l'ordre d'une couche fixe et d'une couche de mémorisation, comme on va le décrire plus en détail ci-après. Les éléments 202A, 204A sont tous deux par exemple orientés de la même façon entre ces noeuds correspondants, par exemple chacun ayant sa couche fixe la plus proche du noeud de mémorisation 206A, 210A correspondant, de sorte qu'ils ont des orientations opposées en ce qui concerne un courant d'écriture passant du noeud de mémorisation 206A vers le noeud de mémorisation 210A ou vice-versa.

Initialement, les signaux AZ1 et CLK1 sont bas, et on suppose que Q1 est initialement bas, et Q̅1̅ est initialement haut. Le signal de données D sur l'entrée de la cellule mémoire 102 est par exemple mis à la valeur qui doit être programmée dans la cellule mémoire, qui dans l'exemple de la figure 4A est un état logique "1" après un front montant 402.

Le signal de phase d'écriture W1 passe ensuite à l'état haut sur un front montant 404, lançant le début de la phase d'écriture. Cela déclenche, peu de temps après, un front montant du signal AZ1, de sorte que le transistor 220A est activé, couplant entre eux les noeuds 208A et 212A. En outre, peu de temps après, le signal d'horloge CLK1 est activé, de sorte que Q1 devient égal au signal de données D. Cela provoque le passage d'un courant dans les éléments résistifs 202A et 204A dans une direction qui va programmer leurs résistances conformément à la valeur de donnée à l'état logique "1" qui doit être programmée. Dans l'exemple de la figure 2, un état haut de la valeur de donnée D correspond par exemple à une valeur haute de la tension Q1, et à une résistance Rₘᵢₙ de l'élément 202A, et une résistance Rₘₐₓ de l'élément 204A. Après l'application du courant pendant une durée suffisante pour établir les états résistifs des éléments 202A et 204A, par exemple pendant une durée t_{W} comprise entre 0,1 ns et 20 ns, le signal AZ1 est amené à l'état bas, ce qui arrête le courant d'écriture, et le signal W1 est ensuite par exemple amené à l'état bas, ce qui termine la phase d'écriture.

La figure 4B est un chronogramme illustrant des exemples des signaux Q̅1̅, W2, AZ2, CLK2, Q2 et Q̅2̅ dans la cellule mémoire 104 pendant une phase d'écriture des états résistifs des éléments résistifs 202B et 204B dans lesquels la valeur de donnée à programmer est l'état logique "0" mémorisé sur le noeud de mémorisation 210A pendant la phase d'écriture de la cellule mémoire 102 illustrée en figure 2. Un front montant 408 du signal d'écriture W2 déclenche un front montant des signaux AZ2 et CLK2, afin de générer un courant à partir du noeud de mémorisation 210B, dans les éléments résistifs 204B et 202B, et vers le noeud de mémorisation 206B, pendant la durée t_{W}. Cela programme une résistance Rₘᵢₙ de l'élément 206B, et une résistance Rₘₐₓ de l'élément 204B.

Le transistor 220A est par exemple dimensionné de telle sorte que le courant d'écriture généré par l'activation de ce transistor soit suffisamment élevé pour programmer les états résistifs des éléments 202A et 204A. De façon similaire, le transistor 220B est par exemple dimensionné de telle sorte que le courant d'écriture généré par l'activation de ce transistor soit suffisamment élevé pour programmer les états résistifs des éléments 202B et 204B. Les dimensions des transistors 220A et 220B, et en particulier au moins leur largeur, sont par exemple différentes entre elles. Par exemple, la largeur du transistor 220A est par exemple plus grande ou plus petite d'au moins 10 pourcent par rapport à la largeur du transistor 220B. En effet, au vu des différentes durées de rétention des éléments résistifs 202A, 204A comparées aux éléments résistifs 202B, 204B, les courants d'écriture dans chacune des cellules mémoires 102, 104 sont par exemple différents. Par exemple, un courant de programmation minimum dans chacune des cellules mémoires 102, 104 pourrait par exemple être compris entre 20 µA et 1,5 mA, et le courant de programmation utilisé dans la cellule mémoire 102 est par exemple plus grand ou plus petit d'au moins 10 pourcent par rapport au courant de programmation utilisé dans la cellule mémoire 104.

Les transistors 214A, 216A, 222A et 224A dans la cellule mémoire 102 sont par exemple dimensionnés de telle sorte que, pendant une phase de transfert lorsque le signal de transfert TR1 est activé, le niveau du courant passant dans les éléments résistifs 202A et 204A soit inférieur à ce qui est nécessaire pour programmer leurs états résistifs, par exemple un niveau compris entre 10 et 90 pourcent en dessous du courant d'écriture correspondant. De façon similaire, les transistors 214B, 216B, 222B et 224B dans la cellule mémoire 104 sont par exemple dimensionnés de telle sorte que, pendant une phase de transfert lorsque le signal de transfert TR2 est activé, le niveau de courant passant dans les éléments résistifs 202B et 204B soit inférieur à celui qui sera nécessaire pour programmer leurs états résistifs, par exemple un niveau inférieur de 10 à 90 pourcent par rapport au courant d'écriture correspondant.

La figure 4A illustre le cas dans lequel la valeur de donnée du signal de données D à l'entrée de la cellule mémoire 102 est écrite dans les éléments résistifs 202A, 204A en activant le signal d'horloge CLK1, et la figure 4B illustre le cas dans lequel la valeur de donnée Q̅1̅ sur le noeud de mémorisation 210A est écrite dans les éléments résistifs 202B, 204B en activant le signal d'horloge CLK2. Dans des variantes de réalisation, les signaux d'horloge CLK1 et/ou CLK2 pourraient rester inactifs, et on pourrait utiliser des circuits d'écriture séparés (non illustrés en figure 2) pour appliquer sélectivement une tension haute sur le noeud de mémorisation 206A ou 210A, et/ou sur le noeud de mémorisation 206B ou 210B, pour créer le courant d'écriture correspondant.

La figure 5 illustre schématiquement le dispositif 100 de la figure 1A plus en détail selon un autre exemple de réalisation dans le cas où le dispositif mémoire est une bascule.

Dans le mode de réalisation de la figure 5, la cellule mémoire 102 comprend des éléments résistifs 202A, 204A ayant chacun une borne couplée à un noeud commun 502A, qui est lui-même couplé à la masse par l'intermédiaire d'un transistor NMOS 504A contrôlé par un signal W̅R̅1̅. L'autre borne de l'élément résistif 202A est couplée à un noeud intermédiaire 506A, qui est lui-même couplé à une tension d'alimentation V_{DD} par l'intermédiaire d'un transistor NMOS 508A et d'un transistor PMOS 510A couplés en série et formant un inverseur. De façon similaire, l'autre borne de l'élément résistif 204A est couplé à un noeud intermédiaire 512A, qui est lui-même couplé à une tension d'alimentation V_{DD} par l'intermédiaire d'un transistor NMOS 514A et d'un transistor PMOS 516A couplés en série et formant un inverseur. Les transistors 508A, 510A, 514A et 516A forment ensemble une bascule de données. Le noeud 518A entre les transistors 508A et 510A forme un noeud de mémorisation de la bascule de données mémorisant une tension Q1, et est couplé aux noeuds de commande des transistors 514A et 516A. Le noeud 520A entre les transistors 512A et 516A forme un autre noeud de mémorisation de la bascule mémorisant une tension Q̅1̅, et est couplé aux noeuds de commande des transistors 508A et 510A. Les noeuds 518A, 520A sont en outre couplés ensemble par l'intermédiaire d'un transistor NMOS 522A contrôlé par un signal AZ1.

La cellule mémoire 104 est par exemple sensiblement identique à la cellule mémoire 102, et les composants ont été référencés avec les mêmes références numériques, excepté que le "A" de chaque référence a été remplacé par un "B". Le transistor 504B est contrôlé par un signal W̅R̅2̅ et le transistor 522B est contrôlé par un signal AZ2. La tension sur le noeud 518B est référencée Q2, et la tension sur le noeud 520B est référencée Q̅2̅.

Le noeud de mémorisation 518A de la cellule mémoire 102 reçoit un signal de données d'entrée D par l'intermédiaire d'un transistor NMOS 524 contrôlé par un signal d'horloge CLK1. Le noeud de mémorisation 520A de la cellule mémoire 102 est couplé au noeud de mémorisation 518B de la cellule mémoire 104 par l'intermédiaire d'un transistor NMOS 526 contrôlé par un signal d'horloge CLK2. Un bloc de commande 526 est par exemple prévu, celui-ci recevant des signaux de phase d'écriture W1 et W2, et des signaux de phase de transfert T1 et T2, et générant les signaux de commande AZ1, AZ2, W̅R̅1̅, W̅R̅2̅, CLK1 et CLK2.

Le fonctionnement du circuit de la figure 5 est similaire à celui du circuit de la figure 2, excepté que la valeur de données D_{NV1} à écrire dans les éléments résistifs 202A, 204A est fournie par l'intermédiaire d'un circuit d'écriture dédié (non illustré en figure 5) couplé aux noeuds 506A et 512A pendant une phase d'écriture, et la valeur de données D_{NV2} à écrire dans les éléments résistifs 202B, 204B est fournie par l'intermédiaire d'un circuit d'écriture dédié (également non illustré en figure 5) couplé aux noeuds 506B, 512B.

Le fonctionnement du circuit de la figure 5 pendant les phases d'écriture et de transfert va maintenant être décrit plus en détail en référence aux figures 6A et 6B.

La figure 6A est un chronogramme illustrant les signaux W1, W̅R̅1̅ et D_{NV1} pendant une phase d'écriture des éléments résistifs 202A et 204A de la cellule mémoire 102 de la figure 5.

Le signal de phase d'écriture W1 par exemple passe à l'état haut sur un front montant 602 au début de la phase d'écriture, déclenchant un front descendant 604 sur le signal W̅R̅1̅, désactivant ainsi le transistor 504A. Peu après, le signal de données D_{NV1} est par exemple appliqué au noeud 506A, et son inverse au noeud 512A, pour générer un courant d'écriture dans une direction à travers les éléments résistifs 202A et 204A qui est basée sur la donnée à programmer. Dans l'exemple de la figure 6A, un niveau de tension haut est appliqué au noeud 506A pendant une période d'écriture t_{W}. Par exemple, comme cela est représenté par les lettres NS, aucun signal n'est appliqué aux noeuds 506A et 512A avant et après la période d'écriture. A la fin de la période d'écriture t_{W}, le signal de phase d'écriture W1 par exemple passe à l'état bas, ce qui déclenche un front montant du signal W̅R̅1̅ pour réactiver le transistor 504A.

Une phase d'écriture des éléments résistifs 202B, 204B de la cellule mémoire 104 est par exemple mise en oeuvre de la même façon que celle de la cellule mémoire 102.

La figure 6B est un chronogramme illustrant les signaux T1, AZ1 et CLK2 pendant une phase de transfert des données représentées par les éléments résistifs 202A, 204A dans la cellule mémoire 102 vers la sortie OUT du dispositif.

Pendant la phase de transfert, le transistor 504A par exemple reste activé. Une phase de transfert est par exemple initiée par un front montant 602 du signal de phase de transfert T1. Cela déclenche, peu après, un front montant du signal AZ1, activant ainsi le transistor 522A. Cela a pour effet d'égaliser dans une certaine mesure les tensions sur les noeuds de mémorisation Q1 et Q̅1̅, et de provoquer le passage d'un courant dans les branches de gauche et de droite de la cellule mémoire 102. Lorsque le signal AZ1 est amené à l'état bas par un front descendant 608, les noeuds de mémorisation Q1 et Q̅1̅ vont aller vers leur état stable le plus proche sur la base des résistances relatives des éléments 202A et 204A. Le signal de phase de transfert T1 passe ensuite par exemple à l'état bas, terminant la phase de transfert.

La donnée transférée est ensuite par exemple fournie à la sortie du dispositif en activant le signal d'horloge CLK2 pour écrire la valeur présente au niveau du noeud de mémorisation 520A dans le noeud de mémorisation 518B.

Les figures 7A et 7B illustrent des exemples des structures d'éléments résistifs à couple de transfert de spin (STT) ayant des durées de rétention différentes selon un exemple de réalisation. Par exemple, les éléments résistifs 106A, 202A et 204A décrits ici ont chacun une structure correspondant à celle de la figure 7A, et les éléments résistifs 106B, 202B, 204B décrits ici ont chacun une structure correspondant à celle de la figure 7B, ou vice-versa.

La figure 7A illustre un élément résistif STT 700 ayant une anisotropie magnétique dans le plan. L'élément 700 est par exemple sensiblement cylindrique, mais a une section qui est non circulaire, par exemple ovale, avec un diamètre maximum dₘₐₓ₁ supérieur au diamètre minimum dₘᵢₙ₁. L'élément 700 comprend des électrodes inférieure et supérieure 702 et 704, chacune ayant sensiblement une forme de disque, et prenant en sandwich un certain nombre de couches intermédiaires entre elles. Les couches intermédiaires comprennent, du bas vers le haut, une couche fixe 706, une barrière d'oxydation 708, et une couche de mémorisation 710.

La barrière d'oxydation 708 est par exemple formée en MgO ou en AlₓO_{y}. La couche fixe 706 et la couche de mémorisation 710 sont par exemple en matériau ferromagnétique, comme du CoFe. La direction de spin dans la couche fixe 706 est fixe, comme cela est représenté par une flèche allant de la gauche vers la droite en figure 7A. Bien sûr, dans des variantes de réalisation, la direction de spin pourrait aller de la droite vers la gauche dans la couche fixe 706. Toutefois, la direction de spin dans la couche de mémorisation 710 peut être changée, comme cela est représenté par des flèches dans des directions opposées en figure 7A. La direction de spin est programmée par la direction du courant d'écriture I qu'on fait passer dans l'élément, de sorte que la direction de spin dans la couche de mémorisation est parallèle, en d'autres termes est dans la même direction, ou est anti-parallèle, en d'autres termes dans la direction opposée, par rapport à celle de la couche fixe 706.

La figure 7B illustre un élément résistif STT 720 ayant aussi une anisotropie magnétique dans le plan. Ici encore, l'élément 720 est sensiblement cylindrique, mais a par exemple une section qui est non circulaire, par exemple ovale, avec un diamètre maximum dₘₐₓ₂ supérieur à un diamètre minimum dₘᵢₙ₂. Pour le reste, les couches formant les éléments 720 sont les mêmes que celles formant l'élément 700, et portent les mêmes références numériques et ne vont pas être décrites de nouveau en détail.

Le rapport entre les diamètres minimum et maximum dₘₐₓ₁/dₘᵢₙ₁ de l'élément 700 est par exemple supérieur au rapport correspondant dₘₐₓ₂/dₘᵢₙ₂ de l'élément 720. En d'autres termes, dmax1 est supérieur à dₘₐₓ₂ et/ou dₘᵢₙ₁ est inférieur à dₘᵢₙ₂. Cela conduit à une durée de rétention de données plus longue pour l'élément 700 comparé à l'élément 720.

Bien que dans les exemples des figures 7A et 7B, les éléments résistifs 700 et 720 soient illustrés avec des sections qui sont de forme ovale, dans des variantes de réalisation, d'autres formes pourraient être possibles, comme la forme rectangulaire.

Il sera clair pour l'homme de l'art qu'il serait possible d'obtenir une différence dans la durée de rétention entre les cellules mémoires 102 et 104 de façon différente de celle des exemples des figures 7A et 7B, en fonction de la technologie particulière employée pour former les éléments. En général, la durée de rétention d'un élément résistif est fonction du produit KV, où K est spécifique du matériau ou de son facteur de forme pour les couches magnétiques d'un élément ayant une anisotropie magnétique dans le plan, et V est le volume de la couche de mémorisation. Ainsi, la durée de rétention d'un élément résistif dépend de la taille, de la forme, de l'épaisseur de sa couche de mémorisation et des types de matériaux utilisés pour former ses couches. Dans certains modes de réalisation, la différence entre la durée de rétention de la cellule mémoire 102, 104 est obtenue en assurant une différence dans une ou plusieurs dimensions correspondantes des éléments résistifs de chaque cellule mémoire, comme l'épaisseur et/ou le volume de la couche de mémorisation. En plus ou à la place, la différence entre les durées de rétention pourrait être obtenue par une différence dans le matériau utilisé pour former une ou plusieurs des couches des éléments résistifs de chaque cellule. Par exemple, une couche fixe et/ou de mémorisation des éléments résistifs de chaque cellule mémoire 102, 104 pourrait être formée par une combinaison appropriée de matériaux sélectionnés dans la liste : Co, Pt, Cr, Pd, Ni, Ta, Fe, B, MgO et AlOx.

Par exemple, dans un autre mode de réalisation, les éléments de mémorisation de données non volatile 106A, 106B sont mis en oeuvre par des éléments résistifs STT ayant une anisotropie magnétique perpendiculaire au plan. Un tel type d'élément résistif programmable a une structure en couche très similaire à celle des éléments dans le plan des figures 7A et 7B, mais est avantageux en ce qu'il peut en général être programmé par un courant d'écriture plus faible. Pour ce type d'élément résistif, la différence de durée de rétention entre les cellules mémoires 102 et 104 est par exemple obtenue par une différence dans le volume d'au moins l'une des couches formant les éléments résistifs. Par exemple, les épaisseurs des couches de mémorisation des éléments STT sont différentes entre elles.

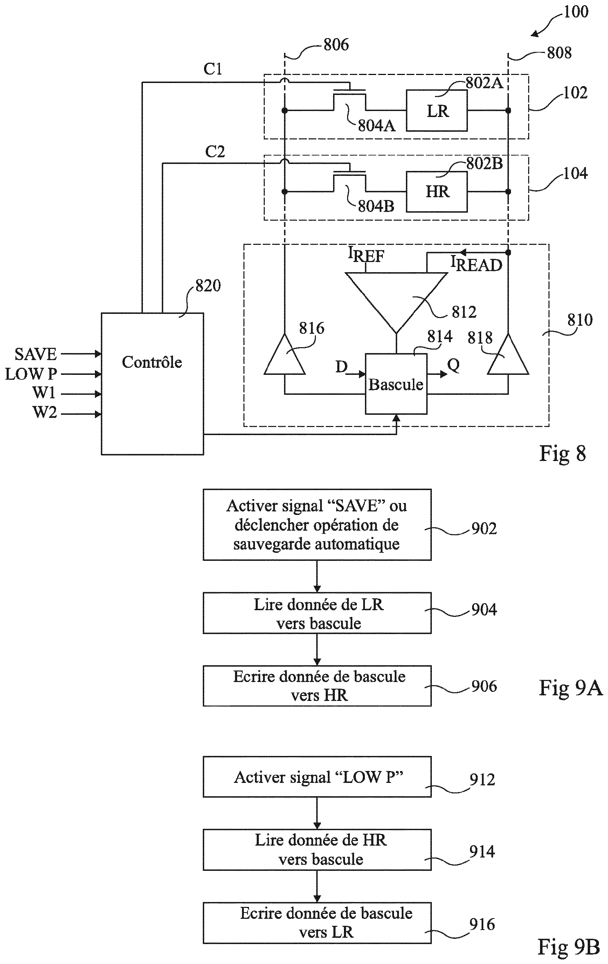

La figure 8 illustre schématiquement le dispositif mémoire 100 de la figure 1A plus en détail selon un autre exemple de réalisation, dans le cas où le dispositif 100 est un réseau mémoire.

Dans le dispositif de la figure 8, la cellule mémoire 102 comprend un élément résistif 802A formant l'élément de mémorisation de donnée non volatile de la cellule et ayant par exemple une durée de rétention relativement faible LR, et la cellule mémoire 104 comprend un élément résistif 802B formant l'élément de mémorisation de donnée non volatile de la cellule et ayant par exemple une durée de rétention relativement élevée HR.

Chacun des éléments 802A, 802B est couplé en série avec un transistor de sélection respectif 804A, 804B entre des lignes de bit 806 et 808. Bien que seulement deux cellules mémoires 102, 104 soient illustrées en figure 8, il pourrait y avoir un nombre quelconque de telles cellules couplées entre les lignes de bit 806, 808. Dans certains modes de réalisation, il y a un nombre égal de cellules LR 102 et de cellules HR 104. Dans certains modes de réalisation, il pourrait aussi y avoir d'autres cellules ayant encore une autre durée de rétention, par exemple située entre celles des cellules LR et HR. En outre, le circuit de chaque cellule 102 représenté en figure 8 n'est qu'un exemple, de nombreux autres agencements étant possibles, comprenant des agencements différentiels avec deux éléments résistifs similaires à ceux des cellules illustrées en figure 2.

Chacune des lignes de bit 806, 808 est couplée à un circuit de lecture-écriture 810, qui permet d'écrire et de lire des données dans les cellules mémoires 102, 104. Le circuit de lecture-écriture 810 comprend par exemple un comparateur 812, ayant une entrée couplée à la ligne de bit 808, et une sortie couplée à une bascule à verrouillage 814. La bascule 814 reçoit par exemple un signal de données D, représentant des données à mémoriser dans le réseau mémoire, et fournit des données Q lues dans une cellule mémoire. La bascule 814 est à son tour couplée à des éléments de pilotage 816, 818, qui ont leurs sorties couplées aux lignes de bit 806 et 808 respectivement.

Un bloc de commande 820 contrôle la bascule 814 et génère des signaux de sélection C1 et C2 pour contrôler les transistors de sélection 804A, 804B respectivement. Le bloc de commande 820 reçoit par exemple un signal "SAVE", indiquant le moment où des données doivent être transférées à partir d'une ou plusieurs cellules LR 102 vers une ou plusieurs cellules HR 104, et un signal "LOW P" indiquant le moment où des données doivent être transférées à partir d'une ou plusieurs cellules HR 104 vers une ou plusieurs cellules LR 102.

En fonctionnement, pendant une phase d'écriture, des données peuvent être écrites dans une cellule LR ou HR, comme cela est déterminé par les signaux W1 et W2.

Lorsque le signal d'écriture W1 est activé, le signal de données D est mémorisé dans la bascule 814, puis est par exemple écrit dans la cellule LR 102. Cela est par exemple obtenu en activant le transistor de sélection 804A, et en appliquant par les éléments de pilotage 816, 818 un courant d'une amplitude et/ou d'une direction permettant de programmer l'élément 802A sur la base de la donnée mémorisée dans la bascule.

Lorsque le signal d'écriture W2 est activé, le signal de données D est mémorisé dans la bascule 814, puis est par exemple écrit dans la cellule HR 104. Cela est par exemple obtenu en activant le transistor de sélection 804B, et en appliquant par les éléments de pilotage 816, 818 un courant d'une amplitude et/ou d'une direction permettant de programmer l'élément 802B sur la base de la donnée mémorisée dans la bascule.

Pendant une phase de lecture, une cellule à lire est sélectionnée en activant le transistor de sélection correspondant, et une tension est par exemple appliquée à la ligne de bit 806 par l'élément de pilotage 816. Le courant I_{READ} sur l'entrée du comparateur 812 est ainsi proportionnel à la résistance programmée de l'élément de mémorisation, et en comparant ce courant à un courant de référence I_{REF}, l'état programmé de l'élément résistif de la cellule peut être détecté par le comparateur 812, et mémorisé dans la bascule 814. Le courant de référence I_{REF} est par exemple généré en appliquant une tension à un élément de résistance égale à une valeur intermédiaire entre les résistances Rₘᵢₙ et Rₘₐₓ des éléments résistifs, ce qui pourrait être mis en oeuvre en couplant deux des éléments de mémorisation en parallèle, mais dans des directions opposées.

En plus des opérations d'écriture et de lecture décrites ci-avant, des données peuvent aussi être transférées entre des cellules LR et HR, comme on va le décrire maintenant en référence aux figures 9A et 9B.

La figure 9A illustre des étapes d'une opération de sauvegarde.

Dans une étape initiale 902, le signal "SAVE" est activé, ou une opération de sauvegarde automatique est déclenchée. Par exemple, le réseau mémoire peut être agencé pour sauvegarder périodiquement les données mémorisées dans une ou plusieurs cellules LR vers une ou plusieurs cellules HR afin de sauvegarder les données. A titre de variante, le bloc de commande 820 peut automatiquement déclencher l'opération de sauvegarde sur la base d'une durée de rétention moyenne déterminée des éléments à faible rétention. Par exemple, le bloc de commande 820 comprend un compteur qui estime la durée de rétention moyenne des éléments à faible durée de rétention dans chaque secteur de la mémoire, par exemple chaque colonne, ligne ou banc d'éléments mémoire. Cette information est ensuite utilisée pour déterminer à quelle fréquence l'opération de sauvegarde doit être effectuée, tout en autorisant une marge appropriée telle qu'aucune donnée ne soit perdue.

Dans une étape suivante 904, une donnée est lue dans la cellule LR 102 pour aller dans la bascule 814, cette opération étant similaire à l'opération de lecture décrite précédemment.

Dans une étape suivante 906, la donnée lue vers la bascule 814 est écrite dans une cellule HR, cette opération étant similaire à une opération d'écriture telle que décrite précédemment.

Les étapes 904 et 906 peuvent être répétées pour d'autres cellules LR dans la colonne de cellules mémoires.

La figure 9B illustre des étapes dans une opération destinée à revenir vers un mode à faible consommation d'énergie.

Dans une étape initiale 912, le signal de faible énergie LOW P est activé.

Dans une étape suivante 914, une donnée est lue de la cellule HR 104 vers la bascule 814, cette opération étant similaire à l'opération d'écriture décrite précédemment.

Dans une étape suivante 916, la donnée est écrite de la bascule 814 vers la cellule LR 102, cette opération étant similaire à une opération d'écriture telle que décrite précédemment.

Les étapes 914 et 916 peuvent être répétées pour d'autres cellules HR dans la colonne de cellules mémoires.

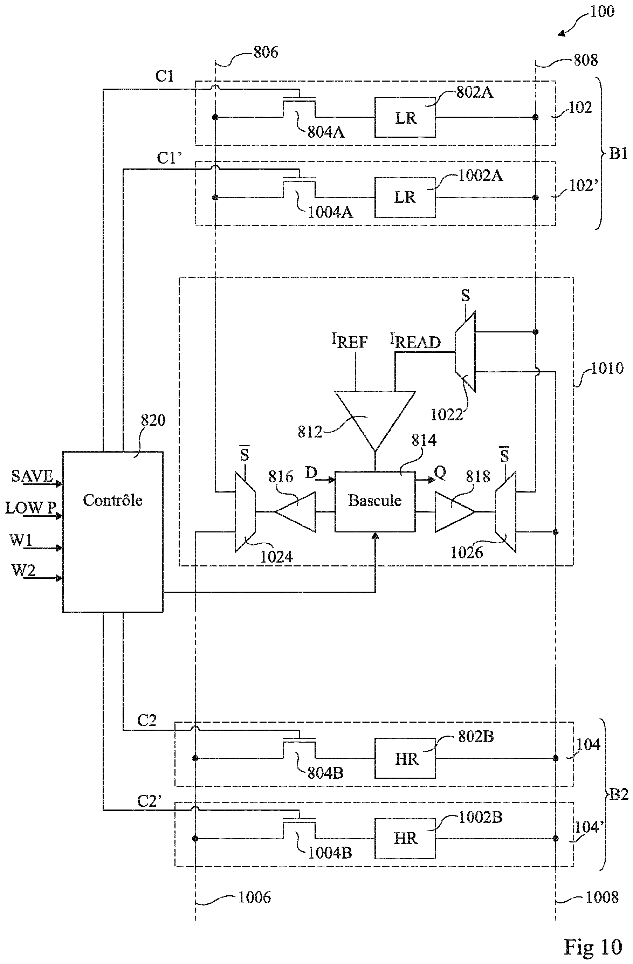

La figure 10 illustre schématiquement plus en détail le dispositif mémoire 100 de la figure 1A selon un autre exemple de réalisation très similaire à celui de la figure 8, et des éléments similaires portent les mêmes références et ne vont pas être décrits de nouveau en détail.

Dans le dispositif de la figure 10, deux bancs séparés de cellules mémoires sont prévus, chacun étant couplé à un circuit de lecture-écriture 1010, qui est commun aux deux bancs de cellules mémoires.

La cellule mémoire 102 fait partie d'un banc B1, avec une autre cellule LR 102', qui comprend un élément résistif 1002A et un transistor de sélection 1004A couplés en série entre les lignes de bit 806 et 808. Bien sûr, le banc B1 peut comprendre beaucoup plus de cellules mémoires, qui sont toutes par exemple des cellules LR.

La mémoire 104 fait partie d'un autre banc B2, avec une autre cellule HR 104'. Les deux cellules mémoires 104 et 104' sont couplées entre des lignes de bit 1006 et 1008, plutôt qu'entre les lignes de bit 806, 808. La cellule 104' comprend un élément résistif 1002B et un transistor de sélection 1004B couplé en série entre les lignes de bit 1006 et 1008.

Le circuit de lecture-écriture 1010 est similaire au circuit 810, excepté qu'il comprend en plus un multiplexeur 1022, et des démultiplexeurs 1024 et 1026. Le multiplexeur 1022 comporte deux entrées couplées respectivement aux lignes de bits 808 et 1008, et une sortie fournissant l'entrée au comparateur 812. Le démultiplexeur 1024 a une entrée couplée à la sortie de l'élément de pilotage 816, et a deux sorties couplées aux lignes de bit 806 et 1006 respectivement. Le démultiplexeur 1026 a une entrée couplée à la sortie de l'élément de pilotage 818, et deux sorties couplées aux lignes de bits 808 et 1008 respectivement. Le multiplexeur 1022 est contrôlé par un signal de sélection S, et les démultiplexeurs 1024, 1026 par exemple sont contrôlés par l'inverse de ce signal de sélection.

Le fonctionnement du dispositif de la figure 10 pendant une opération d'écriture ou de lecture est très similaire à celui du dispositif de la figure 8, excepté que les démultiplexeurs 1024 et 1026, ainsi que les signaux de sélection C1, C1', etc., sont contrôlés afin de sélectionner une cellule mémoire à écrire ou à lire.

Le fonctionnement du dispositif de la figure 10 pendant une opération de transfert est aussi très similaire à celui du dispositif de la figure 8, excepté que lorsqu'une donnée doit être lue, le multiplexeur 1022 est contrôlé pour sélectionner la ligne de bit appropriée 808 ou 1008. En outre, des transferts de données peuvent être réalisés plus rapidement puisque les données peuvent être lues à partir de l'un des bancs de cellules mémoires en même temps que des données sont écrites dans l'autre.

Un avantage des modes de réalisation décrits ici est que, en prévoyant des éléments résistifs programmables ayant des durées de rétention de donnée différentes, l'élément résistif le plus efficace d'un point de vue énergétique pour une durée de rétention souhaitée peut être sélectionné pour une valeur de données donnée, ce qui économise de l'énergie. Par exemple, l'élément résistif ayant la durée de rétention la plus faible peut être utilisé plus fréquemment, et l'élément résistif ayant la durée de rétention la plus longue pourrait être utilisé sporadiquement pour assurer une sauvegarde de données à long terme.

Avec la description ainsi faite d'au moins un mode de réalisation illustratif, diverses altérations, modifications et améliorations apparaîtront facilement à l'homme de l'art.

Par exemple, il sera clair pour l'homme de l'art que la tension d'alimentation V_{DD} dans les divers modes de réalisation pourrait avoir un niveau quelconque, par exemple entre 1 et 3 V, et plutôt que d'être à 0 V, la tension de masse pourrait aussi être considérée comme une tension d'alimentation qui pourrait avoir un niveau quelconque, comme un niveau négatif.

En outre, il sera clair pour l'homme de l'art que dans tous les modes de réalisation décrits ici, tous les transistors NMOS pourraient être remplacés par des transistors PMOS et/ou tous les transistors PMOS pourraient être remplacés par des transistors NMOS. L'homme de l'art saura comment l'un quelconque des circuits pourrait être mis en oeuvre en utilisant uniquement des transistors PMOS ou uniquement des transistors NMOS. En outre, bien qu'on ait décrit ici des transistors basés sur la technologie MOS, dans des variantes de réalisation, on pourrait utiliser d'autres technologies de transistors, comme la technologie bipolaire.

En outre, il sera clair pour l'homme de l'art que les diverses fonctionnalités décrites en relation avec les divers modes de réalisation pourraient être combinées, dans des variantes de réalisation, selon des combinaisons quelconques.

## Revendications

1. Dispositif mémoire comprenant :
une première cellule mémoire (102) comprenant un premier élément résistif de mémorisation de données non volatile (106A, 202A, 802A) programmable pour mémoriser un premier bit de données ; et
une deuxième cellule mémoire (104) comprenant un deuxième élément résistif de mémorisation de données non volatile (106B, 202B, 802B) programmable pour mémoriser un deuxième bit de données ;
dans lequel une caractéristique physique du premier élément résistif est différente d'une caractéristique physique correspondante du deuxième élément résistif d'où il résulte que le premier élément résistif a une première durée de rétention de données, et le deuxième élément résistif a une deuxième durée de rétention de données différente de la première durée de rétention de données, le dispositif mémoire étant configuré pour recevoir un signal de commande indiquant une durée de rétention pour sélectionner l'un des premier et deuxième éléments résistifs pour mémoriser une valeur de donnée d'entrée, ladite durée de rétention étant associée à la valeur de donnée d'entrée ; et
**caractérisé en ce que** :
- chacune des première et deuxième cellules mémoires est couplée à un circuit de lecture-écriture (810, 1010) permettant de lire et d'écrire des données dans les première et deuxième cellules mémoires, le circuit de lecture-écriture comprenant un comparateur (812) ayant une entrée couplée à une première ligne de bit et une sortie couplée à une bascule de verrouillage (814), la bascule de verrouillage étant couplée à son tour à des éléments de pilotage (816, 818), qui ont leur sorties couplées respectivement à la première ligne de bit et à une deuxième ligne de bit, la bascule de verrouillage recevant un signal de données représentant des données à mémoriser dans la première ou deuxième cellule mémoire, et fournissant des données lues d'une des première et deuxième cellules mémoires ;
- le circuit de lecture-écriture (810, 1010) est agencé pour transférer des données entre les première et deuxième cellules mémoires ; et
- la première cellule mémoire est couplée au circuit de lecture-écriture par l'intermédiaire de la première et d'une deuxième ligne de bit (806, 808), et la deuxième cellule mémoire est couplée au circuit de lecture-écriture soit par l'intermédiaire de la première et de la deuxième ligne de bit (806, 808), soit par l'intermédiaire d'une troisième et d'une quatrième ligne de bit (1006, 1008).

2. Dispositif mémoire selon la revendication 1, dans lequel la deuxième durée de rétention de données est au moins 50 pourcent plus courte ou plus longue que la première durée de rétention de données.

3. Dispositif mémoire selon la revendication 2 dans lequel la deuxième durée de rétention de données est au moins 10 fois plus courte ou plus longue que la première durée de rétention de données.

4. Dispositif mémoire selon l'une quelconque des revendications 1 à 3, dans lequel au moins une dimension du premier élément résistif, autre que son épaisseur, est différente d'une dimension correspondante du deuxième élément résistif.

5. Dispositif mémoire selon l'une quelconque des revendications 1 à 4, dans lequel chacun des premier et deuxième éléments résistifs est l'un des éléments suivants :
un élément à couple de transfert de spin ayant une anisotropie dans le plan ;
un élément à couple de transfert de spin ayant une anisotropie perpendiculaire au plan ;
un élément à commutation assistée thermiquement (TAS) ;
un élément à oxydo-réduction (RedOx) ;
un élément ferroélectrique ; et
un élément à changement de phase.

6. Dispositif mémoire selon la revendication 5, dans lequel chacun des premier et deuxième éléments résistifs est un élément à couple de transfert de spin ayant une anisotropie dans le plan ou une anisotropie perpendiculaire au plan et est constitué d'une pluralité de couches empilées, le volume d'au moins l'une des couches du premier élément étant différent de celui de la couche correspondante du deuxième élément résistif.

7. Procédé pour mémoriser une valeur de donnée d'entrée dans une mémoire non volatile d'un dispositif mémoire, le dispositif mémoire comprenant une première cellule mémoire (102) comprenant un premier élément résistif de mémorisation de données non volatile (106A, 202A) programmable pour mémoriser un premier bit de données ; et une deuxième cellule mémoire (104) comprenant un deuxième élément résistif de mémorisation de données non volatile (106B, 202B) programmable pour mémoriser un deuxième bit de données, dans lequel une caractéristique physique du premier élément résistif est différente d'une caractéristique physique correspondante du deuxième élément résistif d'où il résulte que le premier élément résistif a une première durée de rétention de données, et le deuxième élément résistif a une deuxième durée de rétention de données différente de la première durée de rétention de données, et **caractérisé en ce que** :
- chacune des première et deuxième cellules mémoires est couplée à un circuit de lecture-écriture (810, 1010) permettant de lire et d'écrire des données dans les première et deuxième cellules mémoires, le circuit de lecture-écriture comprenant un comparateur (812) ayant une entrée couplée à une première ligne de bit et une sortie couplée à une bascule de verrouillage (814), la bascule de verrouillage étant couplée à son tour à des éléments de pilotage (816, 818), qui ont leur sorties couplées respectivement à la première ligne de bit et à une deuxième ligne de bit, la bascule de verrouillage recevant la valeur de donnée d'entrée et fournissant des données lues d'une des première et deuxième cellules mémoires ;
- le circuit de lecture-écriture (810, 1010) est agencé pour transférer des données entre les première et deuxième cellules mémoires ; et
- la première cellule mémoire est couplée au circuit de lecture-écriture par l'intermédiaire de la première et d'une deuxième ligne de bit (806, 808), et la deuxième cellule mémoire est couplée au circuit de lecture-écriture soit par l'intermédiaire de la première et de la deuxième ligne de bit (806, 808), soit par l'intermédiaire d'une troisième et d'une quatrième ligne de bit (1006, 1008), et **en ce que** le procédé comprend :
sélectionner, sur la base d'une durée de rétention de données associée à la valeur de donnée d'entrée, l'un des premier et deuxième éléments résistifs ; et
programmer l'élément résistif sélectionné pour mémoriser la valeur de donnée d'entrée.

## Patentansprüche

1. Speichervorrichtung, die Folgendes aufweist:
eine erste Speicherzelle (102), die ein erstes resistives nicht-flüchtiges Datenspeicherelement (106A, 202A, 802A) aufweist, das programmierbar ist, um ein erstes Datenbit zu speichern; und
eine zweite Speicherzelle (104), die ein zweites resistives nicht-flüchtiges Datenspeicherelement (106B, 202B, 802B) aufweist, das programmierbar ist, um ein zweites Datenbit zu speichern;
wobei sich eine physikalische Eigenschaft des ersten resistiven Elements von einer entsprechenden physikalischen Eigenschaft des zweiten resistiven Elements unterscheidet, was dazu führt, dass das erste resistive Element eine erste Daten-Haltedauer hat und das zweite resistive Element eine zweite Daten-Haltedauer hat, die sich von der ersten Daten-Haltedauer unterscheidet, wobei die Speichervorrichtung konfiguriert ist zum Empfangen eines Steuersignals, das eine Haltedauer zum Auswählen des ersten oder des zweiten resistiven Elements anzeigt, um einen Eingabedatenwert zu speichern, wobei die Haltedauer mit dem Eingabedatenwert verbunden ist; und
**dadurch gekennzeichnet ist, dass**
die erste und die zweite Speicherzelle jeweils mit einer Lese-Schreib-Schaltung (810, 1010) gekoppelt sind, die es ermöglicht, Daten aus der ersten und der zweiten Speicherzelle zu lesen und in diese zu schreiben, wobei die Lese-Schreib-Schaltung einen Komparator (812) aufweist, der einen mit einer ersten Bitleitung gekoppelten Eingang und einen mit einem Latch (814) gekoppelten Ausgang aufweist, wobei das Latch wiederum mit Ansteuerungselementen (816, 818) gekoppelt ist, deren Ausgänge mit der ersten Bitleitung bzw. einer zweiten Bitleitung gekoppelt sind, wobei das Latch ein Datensignal empfängt, das in der ersten oder zweiten Speicherzelle zu speichernde Daten darstellt, und aus einer der ersten und zweiten Speicherzellen gelesene Daten bereitstellt;
die Lese-Schreib-Schaltung (810, 1010) konfiguriert ist zum Übertragen von Daten zwischen der ersten und der zweiten Speicherzelle; und
die erste Speicherzelle mit der Lese-Schreib-Schaltung über die erste und eine zweite Bitleitung (806, 808) gekoppelt ist, und die zweite Speicherzelle mit der Lese-Schreib-Schaltung entweder über die erste und zweite Bitleitung (806, 808) oder über eine dritte und eine vierte Bitleitung (1006, 1008) gekoppelt ist.

2. Speichervorrichtung nach Anspruch 1, wobei die zweite Daten-Haltedauer mindestens 50 Prozent kürzer oder länger als die erste Daten-Haltedauer ist.

3. Speichervorrichtung nach Anspruch 2, wobei die zweite Daten-Haltedauer mindestens zehnmal kürzer oder länger als die erste Daten-Haltedauer ist.

4. Speichervorrichtung nach einem der Ansprüche 1 bis 3, wobei mindestens eine Abmessung des ersten resistiven Elements, mit Ausnahme seiner Dicke, sich von einer entsprechenden Abmessung des zweiten resistiven Elements unterscheidet.

5. Speichervorrichtung nach einem der Ansprüche 1 bis 4, wobei jedes der ersten und zweiten resistiven Elemente eines der folgenden ist:
ein Spin-Transfer-Torque-Element mit Anisotropie in der Ebene;
ein Spin-Transfer-Torque-Element mit Anisotropie senkrecht zur Ebene;
ein thermisch unterstütztes Schaltelement (TAS = thermally assisted switching);
ein Reduktionsoxid (RedOx)-Element;
ein ferro-elektrisches Element; und
ein Phasenänderungselement.

6. Speichervorrichtung nach Anspruch 5, wobei das erste und das zweite resistive Element jeweils ein Spin-Transfer-Torque-Element mit Anisotropie in der Ebene oder Anisotropie senkrecht zur Ebene ist und aus einer Vielzahl von gestapelten Schichten gebildet ist, wobei sich das Volumen von mindestens einer der Schichten des ersten resistiven Elements von einer entsprechenden Schicht des zweiten resistiven Elements unterscheidet.

7. Verfahren zum Speichern eines Eingangsdatenwertes in einem nichtflüchtigen Speicher einer Speichervorrichtung, wobei die Speichervorrichtung eine erste Speicherzelle (102) mit einem ersten resistiven nichtflüchtigen Datenspeicherelement (106A, 202A), das programmierbar ist, um ein erstes Datenbit zu speichern, und eine zweite Speicherzelle (104), die ein zweites resistives nichtflüchtiges Datenspeicherelement (106B, 202B) aufweist, das programmierbar ist, um ein zweites Datenbit zu speichern, wobei sich eine physikalische Eigenschaft des ersten resistiven Elements von einer entsprechenden physikalischen Eigenschaft des zweiten resistiven Elements unterscheidet, was dazu führt, dass das erste resistive Element eine erste Daten-Haltedauer aufweist und das zweite resistive Element eine zweite Daten-Haltedauer aufweist, die sich von der ersten Daten-Haltedauer unterscheidet, und **dadurch gekennzeichnet, dass**
die erste und die zweite Speicherzelle jeweils mit einer Lese-Schreib-Schaltung (810, 1010) gekoppelt sind, die es ermöglicht, Daten aus der ersten und der zweiten Speicherzelle zu lesen und in diese zu schreiben, wobei die Lese-Schreib-Schaltung einen Komparator (812) aufweist, der einen mit einer ersten Bitleitung gekoppelten Eingang und einen mit einem Latch (814) gekoppelten Ausgang hat, wobei das Latch wiederum mit Ansteuerungselementen (816, 818) gekoppelt ist, deren Ausgänge jeweils mit der ersten Bitleitung und einer zweiten Bitleitung gekoppelt sind, wobei das Latch den Eingangsdatenwert empfängt und aus einer der ersten und zweiten Speicherzellen gelesene Daten bereitstellt;
die Lese-Schreib-Schaltung (810, 1010) konfiguriert ist zum Übertragen von Daten zwischen der ersten und der zweiten Speicherzelle; und
die erste Speicherzelle mit der Lese-Schreib-Schaltung über die erste und zweite Bitleitung (806, 808) gekoppelt ist und die zweite Speicherzelle mit der Lese-Schreib-Schaltung entweder über die erste und zweite Bitleitung (806, 808) oder über eine dritte und eine vierte Bitleitung (1006, 1008) gekoppelt ist, und dass das Verfahren Folgendes aufweist:
Auswählen eines der ersten und zweiten resistiven Elemente auf der Grundlage eine Daten-Haltedauer die mit dem Eingangsdatenwert assoziiert ist; und
Programmieren des ausgewählten resistiven Elements zum Speichern des Eingangsdatenwerts.

## Claims

1. A memory device comprising:
a first memory cell (102) comprising a first resistive non-volatile data storage element (106A, 202A, 802A) programmable to store a first bit of data; and
a second memory cell (104) comprising a second resistive non-volatile data storage element (106B, 202B, 802B) programmable to store a second bit of data;
wherein a physical characteristic of the first resistive element is different from a corresponding physical characteristic of the second resistive element resulting in said first resistive element having a first data retention duration, and said second resistive element having a second data retention duration different from said first data retention duration, the memory device being configured to receive a control signal indicating a retention duration for selecting one of the first and second resistive elements to store an input data value, said retention duration being associated with the input data value; and
**characterised in that**:
- said first and second memory cells are each coupled to read-write circuitry (810, 1010) allowing data to be read from and written to the first and second memory cells, the read-write circuitry comprising a comparator (812) having an input coupled to a first bit line and an output coupled to a latch (814), the latch being coupled in turn to drive elements (816, 818), which have their outputs coupled respectively to the first bit line and to a second bit line, the latch receiving a data signal representing data to be stored to the first or second memory cell, and providing data read from one of the first and second memory cells;
- the read-write circuitry (810, 1010) is configured to transfer data between said first and second memory cells; and
- said first memory cell is coupled to said read-write circuitry via the first and a second bit line (806, 808), and said second memory cell is coupled to said read-write circuitry either via the first and second bit lines (806, 808), or via third and fourth bit lines (1006, 1008).

2. The memory device of claim 1, wherein said second data retention duration is at least 50 percent shorter or longer than said first data retention duration.

3. The memory device of claim 2, wherein said second data retention duration is at least 10 times shorter or longer than said first data retention duration.

4. The memory device of any of claims 1 to 3, wherein at least one dimension of the first resistive element, other than its thickness, is different from a corresponding dimension of the second resistive element.

5. The memory device of any of claims 1 to 4, wherein each of said first and second resistive elements is one of:
a spin transfer torque element with in-plane anisotropy;
a spin transfer torque element with perpendicular-to-plane anisotropy;
a thermally assisted switching (TAS) element;
a reduction oxide (RedOx) element;
a ferro-electric element; and
a phase change element.

6. The memory device of claim 5, wherein said first and second resistive elements are each spin transfer torque elements with in-plane anisotropy or perpendicular-to-plane anisotropy and formed of a plurality of stacked layers, wherein the volume of at least one of the layers of said first resistive element is different from a corresponding layer of said resistive second element.

7. A method of storing an input data value in non-volatile memory of a memory device, the memory device comprising a first memory cell (102) comprising a first resistive non-volatile data storage element (106A, 202A) programmable to store a first bit of data; and a second memory cell (104) comprising a second resistive non-volatile data storage element (106B, 202B) programmable to store a second bit of data, wherein a physical characteristic of the first resistive element is different from a corresponding physical characteristic of the second resistive element resulting in said first resistive element having a first data retention duration, and said second resistive element having a second data retention duration different from said first data retention duration, and **characterised in that**:
- said first and second memory cells are each coupled to read-write circuitry (810, 1010) allowing data to be read from and written to the first and second memory cells, the read-write circuitry comprising a comparator (812) having an input coupled to a first bit line and an output coupled to a latch (814), the latch being coupled in turn to drive elements (816, 818), which have their outputs respectively coupled to the first bit line and to a second bit line, the latch receiving the input data value and providing data read from one of the first and second memory cells;
- the read-write circuitry (810, 1010) is configured to transfer data between said first and second memory cells; and
- said first memory cell is coupled to said read-write circuitry via the first and second bit lines (806, 808), and said second memory cell is coupled to said read-write circuitry either via the first and second bit lines (806, 808), or via third and fourth bit lines (1006, 1008), and **in that** the method comprises:
selecting, based on a data retention duration associated with said input data value, one of said first and second resistive elements; and
programming the selected resistive element to store the input data value.
